**Europäisches Patentamt**

(19) **European Patent Office**

**Office européen des brevets**

(11) Publication number: **0 191 592**
**B1**

(12) **EUROPEAN PATENT SPECIFICATION**

(45) Date of publication of patent specification: **17.10.90**

(21) Application number: **86300764.7**

(22) Date of filing: **05.02.86**

(51) Int. Cl.⁵: **G 03 G 8/00, G 03 G 9/08**

(54) Process for selective transfer of metallic foils to xerographic images.

(30) Priority: **05.02.85 US 698241**

(43) Date of publication of application:
**20.08.86 Bulletin 86/34**

(45) Publication of the grant of the patent:
**17.10.90 Bulletin 90/42**

(84) Designated Contracting States:
**AT BE CH DE FR GB IT LI LU NL SE**

(56) References cited:
**EP-A-0 042 632**
**GB-A-2 002 689**
**US-A-2 955 531**
**US-A-4 205 989**

The file contains technical information
submitted after the application was filed and
not included in this specification

(73) Proprietor: **Esselte Letraset Limited**
St. George's House 195-203 Waterloo Road
London SE1 8XJ (GB)

(72) Inventor: **Nelson, Marshall Aaron**
P.O. Box 8 —
Lansing Illinois (US)

(74) Representative: **McCall, John Douglas et al**
W.P. THOMPSON & CO. Coopers Building
Church Street
Liverpool L1 3AB (GB)

**Description**

The present invention relates to the selective transfer of metallic foil to xerographic images.

The method for obtaining a copy of an original by electrostatic imaging is well known in the art, and is described in U.S. Patent Nos. 2,397,691 and 2,357,809 to Carlson. The method generally comprises:

(1) electrostatically charging a photosensitive plate,

(2) irradiating the plate with actinic radiation to dissipate the charge in exposed areas and form an electrostatic image in unexposed areas;

(3) dusting the plate with a pigmented resin powder carrying an opposite electrostatic charge to the charge of the electrostatic image, such that the powder is attracted and then attached to the image area;

(4) transferring the image from the plate to a copy sheet by mechanical or electrical means; and

(5) fixing the powdered image on the copy sheet or by chemical treatment.

Various patents have disclosed methods for obtaining colour copies. For example, U.S. Patent No. 3,057,720 to Hayford et al. discloses a method for xerographic colour reproduction, wherein the same general xerographic steps as outlined above are used in combination with the known "subtractive principle" of mixing primary colours, in a manner fully described in the '720 patent. U.S. Patent No. 3,088,402 to Newman discloses a method of producing an imaged hectograph master by superposing a transfer sheet coated with a transferable layer of dye-carrying composition upon a sheet including a xerographic image and heating the sheets to render the xerographic image tacky. The transfer sheet is then stripped from the resulting imaged hectograph master. Similarly, U.S. Patent No. 4,066,267 to Kurz, deceased, disclosed placing a coloured transfer donor in face-to-face contact with an image portion of a xerographic copy, heating the xerographic image, and removing the transfer donor to transfer the colour of the donor layer to the image portion of the xerographic copy.

Methods for selective transfer of metallic foils have also been disclosed. For example, U.S. Patent No. 4,053,344 to Hirahara disclosed placing a stamping foil, having an adhesive on one side, over ink which is dried until tacky. The adhesive is of a type which reacts with and adheres to the ink but does not adhere to the article. U.S. Patent No. 3,519,512 to Downs similarly discloses using an ink-type "sensitizer" to adhere metallic foil to a substrate.

GB—A—2,002,689 describes a duplicating stencil produced by bonding an ink impervious layer of a stencil blank to electrostatically produced images on a substrate and stripping the substrate from the stencil blank to remove the substrate from the blank in the image area.

US—A—4,205,989 discloses a dry system image producing element comprising a substrate, a thin metal layer and a photosensitive layer. The element is exposed to light through a desired pattern and this photosensitive layer peeled off to obtain a light barrier pattern made from metal on the substrate.

However, the process of selectively transferring metallic foil to a xerographic toner image is not specifically disclosed by the prior art.

According to the present invention there is provided a selective transfer process comprising the steps of:

providing a receiving substrate having xerographic images thereon and a transfer sheet comprising a carrier film, a metallic layer on said film and an adhesive layer disposed on a surface of the metallic layer removed from the film;

placing the receiving substrate comprising xerographic images in face-to-face contact with the foil transfer sheet to form a sandwich with the xerographic images and the adhesive on the inside;

applying heat and pressure to at least one of the receiving substrate and the transfer sheet to cause the xerographic image to become tacky and the metallic layer to selectively adhere to the images, resulting in a decorated receiving substrate; and

stripping the transfer sheet away from the decorated receiving substrate.

In addition there is provided a transfer assembly as claimed in Claim 19.

Application of heat and pressure to at least one of the sheets comprising xerographic images and the transfer sheet (and preferably to the sandwich), causes the xerographic images to become tacky and cause the metallic layer to selectively adhere to the images. Stripping away the remainder of the transfer sheet leaves a decorated sheet comprising xerographic images overlaid with metal.

The heat is preferably applied at a temperature of from about 200 to 375°F (more preferably about 350°F) [93 to about 190°C (more preferably about 175°C)]. The pressure is preferably applied in a range of from about 1 to about 20 pounds per square inch (more preferably at about 15 pounds per square inch) [about 7 to about 140 kPA (more preferably at about 105 kPA)].

By use of the present invention a quick and easy method of selectively coating the image portions of a substrate with metallic foil may be provided especially in the presently preferred embodiment, which involves passing the sandwich through heated rollers at a suitable temperature and pressure for transferring the foil to the xerographic images.

In a preferred embodiment the sandwich is passed between a pair of rollers, preferably at a rate of from about 254 to 1270 cm per minute (about 100 to 500 inches per minute), more preferably at about 500 cm per minute (about 200 inches per minute).

The present invention will now be further described by way of example with reference to the accompanying drawings, in which:

Figure 1 shows a diagrammatic cross-sectional view of a colour transfer sheet assembly and receiving substrate in use in a preferred embodiment of the present invention.

Figure 2 shows a diagrammatic perspective view of a transfer sheet assembly and receiving substrate for use in a second preferred embodiment of the present invention.

Figure 3 shows a diagrammatic cross-sectional view of the transfer sheet assembly and receiving substrate of Fig. 2 in use in a second preferred embodiment of the present invention.

Figures 4 through 8 show various apparatus with which the various embodiments of the present invention can be performed:

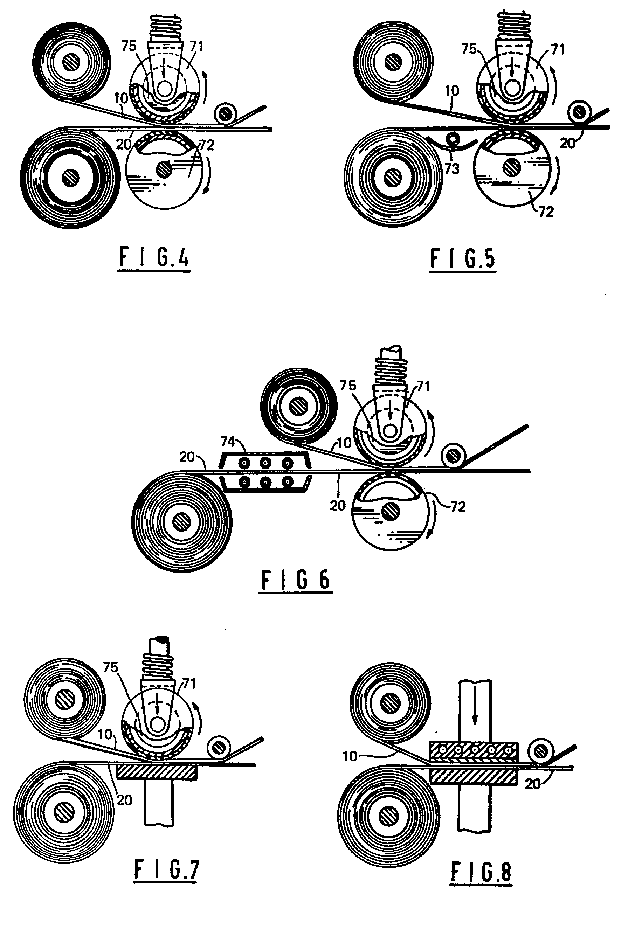

Figure 4 shows a diagrammatic cross-sectional view of a roller pair for use in accordance with an embodiment of the present invention.

Figure 5 shows a diagrammatic cross-sectional view of a roller pair and a pre-heating lamp for use in accordance with an embodiment of the present invention.

Figure 6 shows a diagrammatic cross-sectional view of a roller pair and a pre-heating oven for use in accordance with an embodiment of the present invention.

Figure 7 shows a diagrammatic cross-sectional view of a roller and platen pair for use in accordance with an embodiment of the present invention.

Figure 8 shows a diagrammatic cross-sectional view of a plate pair for use in accordance with an embodiment of the present invention.

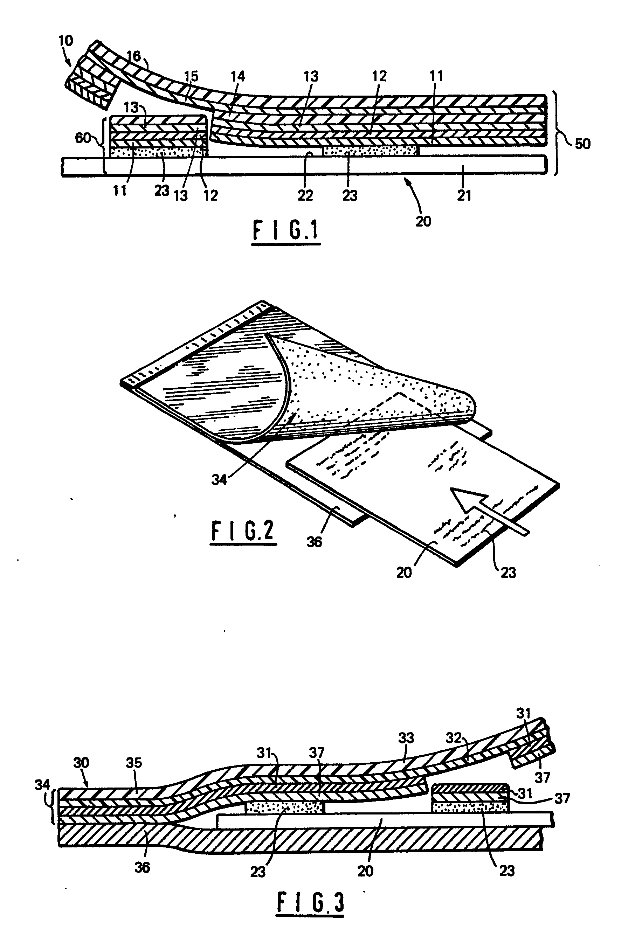

Fig. 1 shows a presently preferred transfer sheet assembly indicated generally as 10, and a receiving substrate, such as paper, indicated generally as 20. The transfer sheet assembly 10 of the preferred embodiment shown in Fig. 1 includes an adhesive 11, a primer 12, a metallic film 13, a clear of coloured polymer coat 14, a release coat 15 and a carrier film 16. The receiving substrate 20 of this preferred embodiment comprises a sheet of paper 21 including an enamel treated surface 22 and xerographic images 23 thereon. For the purposes of this disclosure and the following claims, the term "xerographic images" is to be broadly construed to include clear or pigmented powders deposited by the xerographic or other electrostatic image-forming processes. For example, such "xerographic images" might include polymer powders deposited by only the first four steps of the xerographic process described above while the fifth step may be omitted.

Alternate embodiments are contemplated in which various components shown in Fig. 1 may be omitted or substituted. For example, the transfer sheet assembly 10 may be constructed to include only the metallic film 12, the carrier film 16 and the adhesive layer 11; likewise, the enamel treated surface 22 of the receiving substrate 20 may be omitted, with only an untreated sheet of paper 21 to be used instead. Moreover, the sheet of paper 21 may be substituted with any other sheet material capable of holding xerographic images while being non-adherent with respect to the adhesive 11. For example, a polyester film treated with a high-melting acrylic primer (which has a softening point higher than that of the xerographic toner), can be substituted for the sheet of paper 21.

Accordingly, Figs. 2 and 3 illustrate a much simpler transfer sheet product, indicated generally as 30, to be used in a second preferred embodiment of the invention. The transfer sheet product 30 of Fig. 3 includes a vacuum deposited metallic layer 31 disposed upon a clear or coloured polymer film 32, such as, for example, an acrylic film-like methyl methacrylate or a methacrylate of a methacrylate copolymer, which in turn disposed upon a polyester carrier 33. An adhesive layer 37 preferably coats the metallic layer 31 on the opposite side from the clear polymer film 32. The metallic layer 31, adhesive layer 37, polymer film 32 and the polyester carrier 33 together form a transfer sheet 34 that is adhered at an upper edge 35 to a backing sheet 36.

It should be noted that the transfer sheet assembly 10 or the transfer sheet product 30 can be provided with a backing sheet 36 as seen in Figs. 2 and 3, in which case the receiving substrate is positioned in between the transfer sheet 34 and the backing sheet 36 (as expressly shown in Fig. 2), or in between the transfer sheet assembly 10 and a corresponding backing sheet (not shown in Fig. 1). Accordingly, the preferred embodiments illustrated by the drawings can be varied such that the transfer sheet assembly 10 is in the form of a roll (see, e.g., Fig. 4) or in individual sheet form as in Figs. 2 and 3; and likewise, the transfer sheet product 30 of Fig. 3 can be provided in the form of a roll without the backing sheet 36.

In use, the transfer sheet assembly 10 or the transfer sheet 34 is placed in face-to-face contact with the receiving substrate 20 to form a sandwich 50 with the xerographic images 23 on the inside, as seen in Figs. 1 and 3. Heat and pressure are applied to the sandwich 50, causing the xerographic images 23 to become tacky and causing the metallic foil to selectively adhere to the images 23. The unadhered portion of the transfer sheet assembly 10 or the transfer sheet product 30 is then stripped away from the resulting decorated sheet 60 comprising the xerographic images 23 overlaid with the metal film 13 or the metallic layer 31.

Various means can be used to apply pressure and temperature in accordance with the present invention, examples of which are given in Figs. 4 to 8. Each apparatus in the drawings includes a pair of elements for the application of pressure to the sandwich 50 (formed from the transfer sheet assembly 10 or the transfer sheet product 30, and the receiving substrate 20), and heating means which can be included in one of the pressure application elements and/or upstream the pair of pressure application elements. It is generally preferred that at least one of the pair of pressure application elements be formed of a resilient material at least at the area where contact is to be made with the transfer sheet assembly 10 or transfer sheet product 30, to ensure the desired conformity of opposing surfaces of the pair as the sandwich passes therethrough. The apparatus shown in Fig. 4 represents the presently preferred means for performing these pressure application and heating functions, and will be more fully discussed below. The apparatus shown in Figs. 5 and 6 are similar to that shown in Fig. 4, but include pre-heating means upstream the pair of pressure application elements; Fig. 5 includes a heat lamp 73 and Fig. 6 includes an oven 74. Such preheating means can be used to pre-heat the entire sandwich 50 (i.e., the combined transfer sheet assembly 10 or product 30 and receiving substrate 20), or to simply pre-heat the receiving substrate 20. Embodiments including such preheating means are expected to be highly advantageous in that the rate of travel of the transfer sheet assemblies 10 or the transfer sheet products 30 will be increased, since it will not be necessary to maintain as great a dwell time in the pressure applying portions of the apparatus in order to achieve the desired temperatures in the xerographic images.

In the presently preferred embodiment, the heat and pressure are applied by passing the sandwich 50 through a pair of rollers 70, as shown in Figs. 4. The pair of rollers 70 comprise a first roller 71, made, for example, from teflon coated aluminium, and second roller 72, made, for example, from silicone rubber or having a silicone rubber surface. In this presently preferred embodiment, the first roller 71 is heated by heater 75 to a temperature in the range of from about 200 to about 375 degrees Fahrenheit (about 93 to about 190°C), and most preferably a temperature of about 350 degrees Fahrenheit (about 175°C). The applied pressure is preferably in the range of from about 1 to about 20 pounds per square inch (about 7 to about 140 kPa), and most preferably about 15 pounds per square inch (about 105 kPa). The pressure is applied to a contact area that is preferably of about .05 to about .3 square inch per inch (about 0.3 to about 1.9 cm$^2$ per 2.54 cm) of line contact and most preferably about .15 square inch per inch (about 0.97 cm$^2$ per 2.54 cm) of line contact. This contact area exists due to the slight flattening deformation of the silicone rubber roller 72, which has a hardness in the preferred range of from about 40 to about 80 durometers, and most preferably in the range of from about 50 to about 60 durometers. The presently preferred contact or dwell time is in the range of from about 0.01 to about 0.1 seconds, and most preferably is about 0.05 seconds, such that the sheet feed rate is preferably in the range of from about 100 to 500 inches per minute (about 254 to about 1270 cm/min) and most preferably approximately 200 inches per minute (500 cm/min). For the purpose of the present invention, "dwell" or "contact" time is the period of time during which pressure is applied to the portion of the sandwich in contact with the pair of rollers 70 (or other pressure-applying element) to develop adhesion to the toner and effect transfer. These parameters have been developed in the presently preferred embodiments because of the excellent results they produce when used with the presently preferred transfer sheet assemblies 10 and transfer sheet products 30, each of which will now be described in detail.

The presently preferred embodiments of the transfer sheet assembly 10 includes each of the components shown in Fig. 1. The adhesive 11 in this embodiment is made from an acrylate copolymer containing a dispersion of finely divided silicon dioxide. Such a material can be obtained from Rohm & Haas of Philadelphia, Pennsylvania as ACRYLOID® B48N. The primer 12 is made from vinyl chloride/vinyl acetate/maleic acid copolymer. Such a material can be obtained from Union Carbide as UCAR® Grade UMCH. The metallic film 13 can be made from any of a variety of metals, such as aluminium, copper, chromium, tin, silver and gold, and the like, and in the preferred embodiment is made by vacuum deposition onto methyl methacrylate to a thickness preferably just approaching but not attaining optical opacity. Such vacuum deposited films can be obtained from Gomar Mfg. Co. of Linden, New Jersey. The presently preferred release coat 15 is made from an ethylene vinyl acetate copolymer. Such a material can be obtained from DuPont as ELVAX-40. Finally, the presently preferred carrier film 16 is made from polyester film (extruded and oriented polyethylene terephthalate, having a thickness in a range of 0.4 to 2 mils, i.e., 10 to 50 mm). Such a material can be obtained from ICI America as .5 mil (127 μm) type H film. The adhesive 11, and polymer coats 14 can be applied from an isopropyl acetate solution, while the primer 12 can be applied from a methyl ethyl ketone solution and the described release coat 15 can be applied from a toluol solution. An ideal composite film thickness (i.e., the combined thickness of all coating components except for the carrier film 16) has been found to be in the range of from about .02 mils to about .06 mils, and is optimally about .03 mils (about 5 to about 15 μm, optionally about 7.5 μm). Thicker composite films give decreased image resolution, while thinner composite films lose their integrity upon transfer and induce undesirable optical effects.

It should be understood that the materials and details of construction of the foregoing detailed description are given only by way of illustration, and not limitation. These materials and details of construction can be varied to suit individual applications within the scope of this invention, as will be apparent to one of ordinary skill in the art. For example, the metal need not be vacuum deposited, but can be applied to a coating by the equivalent processes of silver reduction, organic solvent deposition, or the like. Moreover, the polymer coatings can be applied from water-based solutions or dispersions. Accordingly, it is intended that the following claims and not the

## Claims

1. A selective transfer process comprising the steps of:

providing a receiving substrate (20) having xerographic images (23) thereon and a transfer sheet (10, 34) comprising a carrier film (16, 33), a metallic layer (13, 31) on said film and an adhesive layer (11, 37) disposed on a surface of the metallic layer (13, 33) remote from the film (16, 33);

placing the receiving substrate (20) comprising xerographic images (23) in face-to-face contact with the foil transfer sheet (10, 34), to form a sandwich (50) with the xerographic images (23) and the adhesive (11, 37) on the inside;

applying heat and pressure to at least one of the receiving substrate (20) and the transfer sheet (10, 34) to cause the xerographic image (23) to become tacky and the metallic layer (13, 31) to selectively adhere to the images (23), resulting in a decorated receiving substrate (60); and

stripping the transfer sheet (10, 34) away from the decorated receiving substrate (60).

2. A process as claimed in claim 1, in which the receiving substrate (20) is a sheet.

3. A process as claimed in claim 1 or 2 in which said heat and pressure is applied to the sandwich (50).

4. A process as claimed in claim 1, 2 or 3, comprising the additional step of pre-heating the receiving substrate (20) having xerographic images thereon before the step of applying heat and pressure.

5. A process as claimed in any one of the preceding claims, in which the heat is applied at a temperature in a range of from about 93 to 190°C.

6. A process as claimed in any one of the preceding claims, in which the pressure is applied in a range of from about 7 to about 140 kPa.

7. A process as claimed in any one of the preceding claims, in which the transfer sheet (10, 34) is made by vacuum depositing metal on a polymer backing.

8. A process as claimed in any one of the preceding claims, in which the metal is one of the group consisting of aluminium, copper, tin, silver and gold.

9. A process as claimed in any one of the preceding claims, in which the transfer sheet (10, 34) is attached to a backing sheet (36), and the receiving substrate (20) comprising xerographic images is placed between the backing sheet (36) and transfer sheet (10, 34).

10. A process as claimed in any one of the preceding claims, comprising the additional steps of:

providing a pair of rollers (71, 72) adapted to apply heat and pressure to the sandwich (50); and

passing the sandwich (50) through the pair of rollers.

11. A process as claimed in claim 10 comprising the additional step of providing a dwell time of about 0.01 to 0.1 seconds.

12. A process as claimed in claim 10 or 11, in which the sandwich is passed through the rollers (71, 72) at a rate of about 254 to about 1270 cm per minute.

13. A process as claimed in any one of claims 10 to 12, in which the pair of rollers (71, 72) comprises a rigid roller element (71) and a roller element (72) comprising a flexible surface.

14. A process as claimed in claim 13 in which the flexible element is constructed with a silicone rubber surface.

15. A process as claimed in claim 13 or 14, in which the flexible roller element (72) has a surface hardness in a range of from about 40 durometers to about 80 durometers.

16. A process as claimed in any one of claims 10 to 15, in which heat is applied to the sandwich (50) simultaneously with the formation of contact between the sandwich and rollers.

17. A process as claimed in any of the preceding claims, comprising the step of pre-heating the sandwich (50) before applying the heat and pressure.

18. A process as claimed in any of the preceding claims, in which the carrier film (33) is a polymeric carrier film.

19. A transfer assembly comprising a transfer sheet (34) attached at an edge thereof to a backing sheet (36), said transfer sheet (34) comprising a carrier film (33) having a metallic layer (31) disposed thereon, and an adhesive layer (37) disposed on a surface of the metallic layer (31) remote from the carrier film (33).

20. A transfer sheet as claimed in claim 19, comprising a primer layer (12) between said adhesive layer (37) and said metallic layer (31).

21. A transfer sheet as claimed in claim 19 or 20, comprising a clear or coloured polymer coat (32) between said metallic layer (31) and said carrier film (33).

22. A transfer sheet as claimed in claim 21, comprising a release coat (15) between said polymer coat (32) and said carrier film (33).

23. A transfer assembly as claimed in any one of claims 19 to 22, in which said carrier film (33) is a polymeric film.

## Patentansprüche

1. Selektives Übertragungsverfahren, das folgende Schritte umfaßt:

ein Empfängersubstrat (20), das mit xerographischen Abbildungen (23) versehen ist, und ein Übertragungsblatt (10, 34) das eine Trägerfolie (16, 33), eine Metallschicht (13, 31) auf der Folie une eine Klebstoffschicht (11, 37) auf einer von der Folie (16, 33) angekehrten Seite der Metallschicht (13, 33) umfaßt, wird vorgesehen,

das xerographische Abbildungen (23) aufweisende Empfängersubstrat (20) wird in direkten Kontakt mit dem (Metall) folienübertragungsblatt (10, 34) gebracht unter Bildung eines Sandwich (50) mit innenliegenden xerographischen Abbildungen (23) und Klebstoff (11, 37);

Wärme und Druck wird auf das Empfängersubstrat (20) und/oder das Übertragungsblatt (10, 34) angewendet, sodaß die xerographische Abbildung (23) klebrig wird und die Metallschicht (13, 31) selektiv an den Abbildungen (23) haftet und ein Empfängersubstrat (60) mit Dekor entsteht; und

das Übertragungsblatt (10, 34) wird von dem mit Dekor versehenen Empfängersubstrat (60) angezogen.

2. Verfahren nach Anspruch 1, wobei das Empfängersubstrat (20) ein Blatt ist.

3. Verfahren nach Anspruch 1 oder 2, wobei Wärme und Druck auf den Sandwich (50) angewendet werden.

4. Verfahren nach Anspruch 1, 2 oder 3, umfassend den zusätlichen Schritt des Vorheizens des Empfängersubstrats (20) mit den darauf befindlichen xerographischen Abbildungen vor Anwendung von Wärme und Druck.

5. Verfahren nach einem der vorhergehenden Ansprüche, wobei Wärme mit einer Temperatur im Bereich von etwa 93 bis 190°C angewendet wird.

6. Verfahren nach einem der vorhergehenden Ansprüche, wobei Druck in einem Bereich von etwa 7 bis etwa 140 kPa angewendet wird.

7. Verfahren nach einem der vorhergehenden Ansprüche, wobei das Übertragungsblatt (10, 34) durch Vakuumauftrag con Metall auf einen Polymerrücken hergestellt wird.

8. Verfahren nach einem der vorhergehenden Ansprüche, wobei das Metall eines aus der Gruppe, bestehend aus Aluminium, Kupfer, Zinn, Silber und Gold ist.

9. Verfahren nach einem der vorhergegenden Ansprüche, wobei das Übertragungsblatt (10, 34) an einem Unterlagsblatt (36) angebracht ist und das die xerographischen Abbildungen aufweisende Empfängersubstrat (20) zwischen Unterlagsblatt (36) und Übertragungsblatt (10, 34) angeordnet wird.

10. Verfahren nach einem der vorhergehenden Ansprüche, umfassend die zusätzlichen Schritte:

ein Walzenpaar (71, 72), das geeignet ist, Wärme und Druck auf den Sandwich (50) auszuüben, wird vorgesehen; und

der Sandwich (50) wird durch das Walzenpaar durchgeführt.

11. Verfahren nach Anspruch 10, umfassend den zusätzlichen Schritt, daß eine Verweilzeit von etwa 0,01 bis 0,1 Sekunden vorgesehen wird.

12. Verfahren nach Anspruch 10 oder 11, wobei der Sandwich durch die Walzen (71, 72) mit einer Geschwindigkeit von etwa 254 bis etwa 1270 com pro Minute durchgeführt wird.

13. Verfahren nach einem der Ansprüche 10 bis 12, wobei das Walzenpaar (81, 72) ein starres Walzenelement (71) une ein Walzenelement (72) mit elastischer Oberfläche umfaßt.

14. Verfahren nach Anspruch 13, wobei das elastische Element mit einer Silicongummischicht ausgestattet ist.

15. Verfahren nach Anspruch 13 oder 14, wobei das elastische Walzenelement (72) eine Oberflächenhärte im Bereich von etwa 40 Durometer bis etwa 80 Durometer hat.

16. Verfahren nach einem der Ansprüche 10 bis 15, wobei Wärme auf den Sandwich (50) gleichzeitig mit der Herstellung des Kontakts zwischen Sandwich und Walzen angewendet wird.

17. Verfahren nach einem der vorhergehenden Ansprüche, umfassend den Schritt, daß der Sandwich (50) vorgewärmt wird, bevor Wärme und Druck angewendet werden.

18. Verfahren nach einem der vorhergehenden Ansprüche, wobei die Trägerfolie (33) eine polymere Trägerfolie ist.

19. Übertragungsanordnung, umfassend ein Übertragungsblatt (34), das an einer seiner Kanten an einem Unterlagsblatt (36) angebracht ist, wobei das Übertragungsblatt (34) eine Trägerfolie (33) mit einer darauf aufgebrachten Metallschicht (31) und eine auf einer von der Trägerfolie (33) abgekehrten Seite der Metallschicht (31) angeordnete Klebstoffschicht (37) aufweist.

20. Übertrgungsblatt nach Anspruch 19, umfassend eine Grundierungsschicht (12) zwischen Klebstoffschicht (37) und Metallschicht (31).

21. Übertragungsblatt nach Anspruch 19 oder 20, umfassend eine transparente oder gefärbte Polymerschicht (32) zwischen der Metallschicht (31) und der Trägerfolie (33).

22. Übertragungsblatt nach Anspruch 21, umfassend eine Ablösebeschichtung (15) zwischen Polymerschicht (32) und Trägerfolie (33).

23. Übertragungsanordnung nach einem der Ansprüche 19 bis 22, wobei die Trägerfolie (33) eine Polymerfolie ist.

**Revendications**

1. Procédé de transfert sélectif incluant les étapes consistant à:

prévoir un substrat récepteur (20) portant des images xérographiques (23), et une feuille de transfert (10, 34) comportant une pellicule de support (16, 33), une couche métallique (13, 31) située sur ladite pellicule et une couche adhésive (11, 37) disposée sur une surface de la couche métallique (13, 33) dans une position distante de la pellicule (16, 33),

placer le substrat récepteur (20) portant des images xérographiques (23) en contact, face-à-face, avec la feuille de transfert (10, 34) de manière à former une structure sandwich (50) avec les images xérographiques (23) et l'adhesif (11, 37) sur le côté intérieur,

appliquer une chaleur et une pression au moins au substrat récepteur (20) ou à la feuille de transfert (10, 34) de manière que l'image xérographique (23) devienne collante, et à la couche métallique (13, 31) de manière qu'elle adhère de façon sélectiv aux images (23), ce qui sonduit à l'obtention d'un substrat récepteur décoré (60); et

décoller la feuille de transfert (10, 34) du substrat récepteur décoré (60).

2. Procédé selon la revendication 1, selon lequel le substrat récepteur (20) est une feuille.

3. Procédé selon l'une des revendications 1 ou 2, selon lequel ladite chaleur et ladite pression sont appliquées à la structure sandwich (50).

4. Procédé selon la revendication 1, 2 ou 3, incluant l'étape additionnelle consistant à chauffeur préalablement le substrat récepteur (20) portant des images xérographiques, avant l'étape d'application d'une chaleur et d'une pression.

5. Procédé selon l'une quelconque des revendications précédentes, selon lequel la chaleur est appliquée à une température située dans une gamme allant d'environ 93 à 190°C.

6. Procédé selon l'une quelconque des revendications précédentes, selon lequel la pression est appliquée dans une gamme comprise entre environ 7 et environ 140 kPa.

7. Procédé selon l'une quelconque des revendications précédentes, selon lequel la feuille de transfert (10, 34) est formée au moyen du dépôt sous vide d'un métal sur un support polymérique.

8. Procédé selon l'une quelconque des revendications précédentes, selon lequel le métal fait partie du groupe incluant l'aluminium, le cuivre, l'étain, l'argent et l'or.

9. Procédé selon l'une quelconque des revendications précédentes, selon lequel la feuille de transfert (10, 34) est fixée à une feuille de support (36), et le substrat récepteur (20) portant les images xérographiques est placé entre la feuille de support (36) et la feuille de transfert (10, 34).

10. Procédé selon l'une quelconque des revendications précédentes, incluant les étapes additionnelles consistant à:

prévoir un couple de galets (71, 72) aptes à appliquer une chaleur et une pression à la structure sandwich (50); et

faire passer la structure sandwich (50) entre les galets du couple de galets.

11. Procédé selon la revendication 10, incluant l'étape additionnelle consistant à prévoir un temps de repos d'environ 0,01 à 0,1 seconde.

12. Procédé selon la revendication 10 ou 11, selon lequel on fait passer la structure sandwich entre les galets (71, 72) à une vitesse comprise entre environ 245 et environ 1270 cm par minute.

13. Procédé selon l'une quelconque des revendications 10 à 12, selon lequel le couple de galets (71, 72) comprend un élément formant galet rigide (71) et un élément formant galet (72) possédant une surface flexible.

14. Procédé selon la revendication 13, selon lequel l'élément flexible comporte une surface formée d'un caoutchouc silicone.

15. Procédé selon la revendication 13 ou 14, selon lequel l'élément formant galet flexible (72) possède une dureté superficielle située dans une gamme comprise entre environ 40 et environ 80.

16. Procédé selon l'une quelconque des revendications 10 à 15, selon lequel une feuille est appliquée à la structure sandwich (50) en même temps qu'un contact entre la structure sandwich et les galets est établi.

17. Procédé selon l'une quelconque des revendications précédentes, incluant l'étape consistant à chauffer préablement la structure sandwich (50) avant l'application de la chaleur et de la pression.

18. Procédé selon l'une quelconques des revendications précédentes, selon lequel la pellicule de support (33) est une pellicule de support polymérique.

19. Dispositif de transfert comprenant une feuille de transfert (34) fixée, au niveau de l'un de ses bords, à une feuille de support (36), ladite feuille de transfert (34) comportant une pellicule de support (33) sur laquelle est disposée une couche métallique (31), et une couche adhésive (31), à distance de la pellicule de support (33).

20. Feuille de transfert selon la revendication 19, comprenant une couche de fond (12) entre ladite couche adhésive (37) et ladite couche métallique (31).

21. Feuille de transfert selon la revendication 19 ou 20, comprenant un revêtement polymérique transparent ou coloré (32) situé entre ladite couche métallique (31) et ladite pellicule de support (33).

22. Feuille de transfert selon la revendication 21, comprenant un revêtement de décollement (15) disposé entre ledit revêtement polymérique (32) et ladite pellicule de support (33),

23. Ensemble de transfert selon l'une quelconque des revendications 19 à 22, dans lequel ladite pellicule de support (33) est une pellicule polymérique.

F I G.1

F I G.2

F I G.3

1

FIG.4

FIG.5

FIG 6

FIG.7

FIG.8